# EUROPÄISCHE PATENTSCHRIFT

(11) **EP 2 319 813 B1**
(45) Veröffentlichungstag und Bekanntmachung des Hinweises auf die Patenterteilung: **26.12.2012**
(21) Anmeldenummer: 09174020.9
(22) Anmeldetag: 26.10.2009
(51) Int. Cl.: C03C 17/00, H01L 31/0236, H01L 31/052

(54) **Strukturierte Glasscheibe und ein Photovoltaik-Modul mit einer solchen Glasscheibe**
Structured glass pane and a photovoltaic module with such a glass pane
Vitre structurée et un module photovoltaïque doté d'une telle vitre

(43) Veröffentlichungstag der Anmeldung: 11.05.2011
(73) Patentinhaber: Saint-Gobain Glass France, 92400 Courbevoie (FR)
(72) Erfinder: Nagorsen, Silke, 52070 Aachen (DE); Herberg, Diana, 52066 Aachen (DE); Werner, Katja, 52152 Simmerath (DE); Bergs, Bianca, 52511 Geilenkirchen (DE); Chorus, Elke, 52072 Aachen (DE); Neumann, Dirk, 52134 Herzogenrath (DE); Prast, Marc-Oliver, 52134 Herzogenrath (DE)
(74) Vertreter: Lendvai, Tomas

(56) Entgegenhaltungen:
- WO-A1-02/064518
- WO-A1-2004/089841
- CH-A5- 693 771

## Beschreibung

Die vorliegende Erfindung betrifft eine strukturierte Glasscheibe und ein Photovoltaik-Modul mit einer solchen Glasscheibe.

In der Patentanmeldung DE 37 11 748 A1 werden ein transparentes Glas und ein Photovoltaik-Modul mit einem solchen transparenten Glas, offenbart. Das transparente Glas ist durch Vertiefungen in der Oberfläche mattiert. Die Vertiefungen werden in die Glasoberfläche geätzt. Wenigstens 30 % des sichtbaren Lichtes wird an den Oberflächenvertiefungen gestreut.

Aus der Patentanmeldung DE 199 01 273 A1 ist ein Photovoltaik-Modul für den Einbau in Fahrzeugen bekannt. Das Photovoltaik-Modul ist mit einer Photovoltaikzelle und einer Schutzschicht auf der dem Lichteinfall zugewandten Seite versehen. Die Schutzschicht ist so ausgebildet, dass sie als ästhetisches Gestaltungsmittel dient.

WO 2009/126745 offenbart eine Methode zur Erhöhung des Wirkungsgrades und der Ästhetik von Photovoltaik-Modulen. Eingestrahltes Licht wird an der Oberfläche von mikrostrukturierten Photovoltaikzellen gestreut und an internen Oberflächen über Totalreflektion zur Photovoltaikzelle zurückgestreut.

Der vorliegenden Erfindung liegt die Aufgabe zugrunde, eine Glasscheibe mit stark lichtstreuender Oberflächenstruktur bereitzustellen, welche eine makroskopisch homogene, ästhetische Oberfläche und eine hohe Lichttransmission aufweist.

Es ist weiter Aufgabe der vorliegenden Erfindung, ein Photovoltaik-Modul mit einer solchen Glasscheibe bereitzustellen, welches eine makroskopisch homogene, ästhetische Oberfläche und einen gleichzeitig hohen elektrischen Wirkungsgrad aufweist.

Die Aufgaben werden durch die in den unabhängigen Patentansprüchen 1 und 12 aufgeführten Merkmale gelöst. Bevorzugte Ausgestaltungen der Erfindung sind durch die Merkmale der abhängigen Patentansprüche gegeben.

Eine erfindungsgemäß strukturierte, hochtransparente Glasscheibe zeigt vorteilhafter Weise eine sehr hohe Lichtstreuung, eine sehr hohe Energietransmission und eine makroskopisch homogene Oberfläche mit ansprechender Ästhetik.

Makroskopisch homogen bedeutet hier, dass ein Betrachter keine klaren Muster, Reflektionen oder Artefakte auf der Oberfläche erkennt. Die erfindungsgemäße makroskopisch homogene Oberfläche lässt auch durch die Glasscheibe hindurch betrachtete Formen und Oberflächen stark mattiert und unscharf erscheinen. Durch die Glasscheibe betrachtete Formen und Oberflächen sind undeutlich oder schemenhaft auf der erfindungsgemäßen strukturierten Glasoberfläche abgebildet.

Die Energietransmission berechnet sich aus der Lichttransmission im Wellenlängenbereich von 300 nm bis 2500 nm, welche gemäß DIN EN 410 AM1 mathematisch mit dem Sonnenspektrum gefaltet wird. Das Transmissionsspektrum kann beispielsweise mit einem PerkinElmer Lambda 900 Spektrometer gemessen werden. Zur Minimierung der Messungenauigkeiten aufgrund der stark streuenden Eigenschaften befindet sich zwischen der strukturierten Oberfläche und dem Detektor eine Lichtsammelkugel (Ulbricht-Kugel).

Die Energietransmission ist besonders bevorzugt im Wellenlängenbereich von 350 nm bis 1200 nm maximal. Licht dieser Wellenlängen kann von Photovoltaikzellen direkt in elektrischen Strom umgewandelt werden.

Der Mittenrauwert Ra nach DIN EN 4287 ist der arithmetische Mittelwert der Beträge aller Profilwerte des Rauheitsprofils. Die mittlere Rillenbreite Rsm ist nach DIN EN 4287 der arithmetische Mittelwert der Breiten der Profilelemente des Rauheitsprofils. Die Rautiefe Rz nach DIN EN 4287 ist der arithmetische Mittelwert der Summe der höchsten Profilspitze und des tiefsten Profiltals aufeinanderfolgender Messstrecken. Die Rauheitsgrößen können beispielsweise mit einem Perthometer Concept der Firma Mahr, Göttingen, gemessen und berechnet werden.

Die hochtransparente Glasscheibe weist bevorzugt eine Energietransmission von mindestens 80 % und bevorzugt mindestens 87 % auf. Die hochtransparente Glasscheibe enthält bevorzugt 60 Gew.% bis 75 Gew.% SiO₂, 0 Gew.% bis 10 Gew.% Al₂O₃, 0 Gew.% bis 5 Gew.% B₂O₃, 5 Gew.% bis 15 Gew.% CaO, 0 Gew.% bis 10 Gew.% MgO, 5 Gew.% bis 20 Gew.% Na₂O, 0 Gew.% bis 10 Gew.% K₂O, 0 Gew.% bis 5 Gew.% BaO, >0,2 Gew.% bis 0,4 Gew.% SO₃, 0 Gew.% bis 0,015 Gew.% Fe₂O₃ (Gesamteisen) und ein Verhältnis FeO zu Fe₂O₃ (Gesamteisen) von 0,2 bis 0,4, besonders bevorzugt etwa 0 Gew.% B₂O₃ oder etwa 0 Gew.% BaO.

Die Erfindung weist die Oberflächenstruktur der hochtransparenten Glasscheibe einen Mittenrauwert Ra von 2,0 µm bis 3,5 µm auf. Mit diesen Mittenrauwerten wird eine besonders hohe Lichtstreuung, bei gleichzeitig hoher Energietransmission erzielt.

Die Erfindung weist die Oberflächenstruktur der transparenten Glasscheibe eine mittlere Rillenbreite Rsm von 80 µm bis 120 µm auf. Mit dieser Rillenbreite wird eine besonders hohe Lichtstreuung bei gleichzeitig hoher Energietransmission erzielt.

Die Erfindung weist die Oberflächenstruktur der transparenten Glasscheibe eine Rautiefe Rz von 5 µm bis 50 µm auf. Mit diesen Rautiefen wird eine besonders hohe Lichtstreuung, bei gleichzeitig hoher Energietransmission erzielt.

Einfallendes Licht wird an den erfindungsgemäßen Oberflächenstrukturen stark gestreut. Als Maß für die Lichtstreuung ist der Haze-Wert gemäß ASTM D 1003 üblich. Der Haze-Wert ist das Verhältnis in Prozent von der gestreuten Lichtmenge, mit einer Abweichung von mehr als 2,5 ° von der Richtung des einfallenden Lichtstrahls zur Gesamttransmission. Der Haze-Wert kann beispielweise mit einem Gerät haze -guard plus ® von BYK Gardner GmbH, Geretsried, gemessen werden.

In der weiteren Ausgestaltung der Erfindung weist die Oberflächenstruktur eine Lichtstreuung von mindestens 70 %, bevorzugt mindestens 90% und besonders bevorzugt mindestens 92 % auf. Die hohe Lichtstreuung bewirkt eine makroskopisch homogene, ästhetische Oberfläche der hochtransparenten Glasscheibe.

In einer weiteren, bevorzugten Ausführungsform der Erfindung weist die erfindungsgemäß strukturierte Glasscheibe eine Energietransmission von mindestens 80 %, bevorzugt mindestens 87 % und besonders bevorzugt mindestens 90 % auf. Die erfindungsgemäße, strukturierte Glasscheibe weist bei makroskopisch homogener Ästhetik nur geringe Absorptionsverluste auf.

Die erfindungsgemäße hochtransparente Glasscheibe kann einseitig oder beidseitig strukturierte Oberflächen aufweisen, bevorzugt einseitig, besonders bevorzugt kann umlaufend der Rand der strukturierten Seite der Glasscheibe unstrukturiert ausgeführt sein. Der Rand kann eine Breite von 0,1 mm bis 100 mm aufweisen, bevorzugt 1 mm bis 5 mm. Bevorzugt ist eine Oberfläche jedoch ganzflächig strukturiert. Eine bevorzugte Ausführungsform liegt vor, wenn eine Seite der hochtransparenten Glasscheibe eine strukturierte Oberfläche und eine Seite der Glasscheibe die ursprüngliche Glasoberfläche aufweist.

In einer weiteren, bevorzugten Ausführungsform der Erfindung weist die hochtransparente Glasscheibe einseitig und vollflächig die Oberflächenstruktur auf.

Die erfindungsgemäßen, strukturierten Glasscheiben sind in einer bevorzugten Ausführungsform 0,5 m² bis etwa 20 m² groß. Bevorzugt weist die strukturierte Glasscheibe Größen von 2 m² bis 5 m² auf. Diese Ausmaße sind für Fassaden- oder Dachelemente, insbesondere in Gebäuden integrierte Photovoltaik-Module üblich.

In einer weiteren, bevorzugten Ausführungsform der Erfindung ist die strukturierte Glasscheibe gewöhnlich ein Sicherheitsglas gemäß DIN EN 12150-1, um die Anforderungen an Bau- oder Architekturverglasungen zu erfüllen.

Die erfindungsgemäße, strukturierte Glasscheibe kann in einem erfindungsgemäßen Photovoltaik-Modul eingesetzt werden.

Das erfindungsgemäße Photovoltaik-Modul umfasst eine erfindungsgemäße strukturierte Glasscheibe, wobei die Oberflächenstruktur dem Lichteinfall zugewandt ist und mindestens eine Zwischenschicht auf der dem Lichteinfall abgewandten Oberfläche der strukturierten Glasscheibe aufgebracht ist, auf der Zwischenschicht eine Schaltung von Photovoltaikzellen aufgebracht ist und eine weitere Zwischenschicht und/oder Schutzschicht auf der Schaltung von Photovoltaikzellen aufgebracht ist.

Durch die Lichtstreueigenschaften der erfindungsgemäßen, strukturierten Glasscheibe wird Licht unter stark variierendem Winkel und nicht senkrecht mit einem verlängerten Lichtpfad in die Photovoltaikzellen eingestrahlt. Damit erhöht sich der elektrische Wirkungsgrad des erfindungsgemäßen Photovoltaik-Moduls, insbesondere für Photovoltaik-Module mit Photovoltaikzellen, die Sonnenlicht nur gering absorbieren.

Ein optimierter Lichtpfad im Photovoltaik-Modul mit einem möglichst langen Absorptionsweg im Material der Photovoltaikzellen ist insbesondere für Photovoltaikzellen mit niedrigem Absorptionskoeffizienten, wie beispielsweise Silizium erforderlich. Dünne Schichten von Silizium absorbieren Sonnenlicht nur sehr schwach. Amorphe und mikrokristalline Silizium-Photovoltaikzellen weisen eine Dicke von 100 nm bis 3000 nm auf. Dünnschicht-Photovoltaikzellen enthalten bevorzugt ein Fremdsubstrat. Das Fremdsubstrat dient als mechanisch stabiler Träger. Die Dünnschicht-Photovoltaikzellen können auch Verbindungshalbleiter, bevorzugt Chalcopyrit oder Kadmium-Tellurid enthalten.

In einer besonders bevorzugten Ausführungsform bestehen die Photovoltaikzellen aus multikristallinen oder monokristallinen Silizium-Halbleitermaterial. Die Silizium-Photovoltaikzellen haben eine Dicke von 100 µm bis 500 µm. Die multikristallinen und monokristallinen Silizium-Photovoltaikzellen sind mechanisch relativ stabil und benötigen kein Fremdsubstrat. Einzelne multikristalline oder monokristalline Silizium-Photovoltaikzellen sind über elektrisch leitfähige Metallkontakte und Stromsammelschienen zu einer Schaltung verbunden. Bevorzugt weisen die Silizium-Photovoltaikzellen feine Stromsammelstrukturen auf der dem Licht zugewandten Oberfläche auf.

Gegenstände und deren Oberflächen erscheinen durch die strukturierte Glasscheibe betrachtet mattiert. Insbesondere erscheinen die Formen und Oberflächen einer Schaltung von mindestens einer Photovoltaikzelle und Stromsammelschienen mattiert und unscharf. Es liegt eine makroskopisch homogenisierte Oberfläche für einen Betrachter vor.

Der Grad der Mattierung und Unschärfe von Körpern und deren Oberflächen, betrachtet durch die erfindungsgemäß strukturierte Glasscheibe, wird wesentlich durch Abstand D beeinflusst. D ist der nächstliegende Abstand von Körpern, wie Photovoltaikzellen oder Stromsammelschienen, zu der dem Körper abgewandten strukturierten Oberfläche der Glasscheibe.

In einer bevorzugten Ausführungsform des erfindungsgemäßen Photovoltaik-Moduls ist der Abstand D 1,8 mm bis 10 mm und bevorzugt 3,5 mm bis 8 mm und besonders bevorzugt 3,7 mm bis 7 mm.

In dem erfindungsgemäßen Photovoltaik-Modul erscheinen Formen und Oberflächen der Photovoltaikzellen, Metallkontakte, Stromsammelschienen und Stromsammelstrukturen auf den Photovoltaikzellen stark mattiert, schemenhaft oder unscharf. Für den Betrachter zeigt sich somit eine makroskopisch homogenisierte Abbildung der Schaltung von Solarzellen. Mit multikristallinen oder monokristallinen Silizium-Photovoltaikzellen werden besonders gute Ergebnisse einer makroskopisch homogenisierten Oberfläche des Photovoltaik-Moduls erzielt.

Der Abstand D zwischen der Photovoltaikzellenoberfläche und der strukturierten Oberfläche der Glasscheibe wird von der Dicke der mindestens einen Zwischenschicht und der Dicke der Glasscheibe bestimmt. Neben verbesserten Lichtstreueigenschaften im Photovoltaik-Modul werden die Photovoltaik-Zellen in ihrer Position fixiert und das Eindringen von Feuchtigkeit über den Modulrand verhindert.

Die Zwischenschicht kann Silikatglas, Ethylen-Vinyl-Acetate (EVA), Ethyl-Acryl-Acetate, Ethylen-Methacrylate, Metallocene, katalysierte Polyethylene, plastizierte Polyvinylchloride, plastizitierte Polyvinyl-Butyrale, Polyethylen-Terephthalate, Polystyrol, Polyamid, Polyester, Polyvinylchlorid, Polycarbonat, Polymethylmethacrylat und / oder Polyurethane, sowie Kopolymere und / oder Gemische davon enthalten.

Die Zwischenschicht kann als Verbundaufbau aus mindestens einer transparenten, haftvermittelnden Zwischenschicht und weiteren, bevorzugt starren, hochtransparenten Zwischenschichten bestehen, um den erforderlichen Abstand D bereitzustellen.

Der erfindungsgemäße Aufbau, ausgeführt als Laminat, wird unter Wärme, sowie Druck und / oder Vakuum dauerhaft zu einem Photovoltaik-Modul laminiert.

Vorteilhaft kann das erfindungsgemäße Photovoltaik-Modul als Glas / Glas Modul ausgeführt sein. Eine dem Lichteinfall abgewandte weitere Zwischenschicht enthält EVA, Ethyl-Acryl-Acetate, Ethylen-Methacrylate, Metallocene, katalysierte Polyethylene, plastizierte Polyvinylchloride, plastizitierte Polyvinyl-Butyrale und / oder Polyurethane, sowie Kopolymere und / oder Gemische davon. Eine äußere Schutzschicht auf der dem Lichteinfall abgewandten Seite enthält bevorzugt Silikatglas.

In einer alternativen Ausführungsform ist das Photovoltaik-Modul als nicht transparentes Laminat ausgeführt. Die dem Lichteinfall abgewandte Schutzschicht enthält bevorzugt Polyvinylfluorid. Ein handelsübliches Material ist Tedlar ® von E.I. du Pont.

Der erfindungsgemäße Aufbau, ausgeführt als Glas / Glas Verbund ist unter Wärme, sowie Druck und / oder Vakuum dauerhaft zu einem Photovoltaik-Modul verbunden.

Das erfindungsgemäße Photovoltaik-Modul lässt sich insbesondere als Fassaden- oder als Dachelement in die Gebäudehülle integrieren, insbesondere für in Gebäude integrierte Photovoltaik-Module.

Das erfindungsgemäße Photovoltaik-Modul wird bevorzugt als Fassaden- oder Dachelement in der Bau- oder Architekturverglasung verwendet.

Ein Ausführungsbeispiel der Erfindung ist in den Figuren 2 bis 7 dargestellt und wird im Folgenden näher beschrieben. Ein Vergleichsbeispiel nach dem Stand der Technik wird gemäß Figur 1 beschrieben.

Es zeigen
Figur 1 eine Draufsicht auf ein Photovoltaik-Modul (II) nach dem Stand der Technik,
Figur 2 eine Draufsicht auf ein erfindungsgemäßes Photovoltaik-Modul (II) mit einer erfindungsgemäßen Glasscheibe (I),
Figur 3 einen Querschnitt A-A' gemäß der Figur 2, durch ein erfindungsgemäßes Photovoltaik-Modul (II) mit einer erfindungsgemäßen Glasscheibe (I),
Figur 3a ein Detail des Querschnitts A-A' gemäß der Figur 3, durch ein erfindungsgemäßes Photovoltaik-Modul (II) mit einer erfindungsgemäßen Glasscheibe (I),
Figur 4 einen alternativen Querschnitt A-A' gemäß der Figur 2, durch ein erfindungsgemäßes Photovoltaik-Modul (II) mit einer erfindungsgemäßen Glasscheibe (I) und mehreren Zwischenschichten,
Figur 4a ein Detail des alternativen Querschnitts A-A' gemäß der Figur 4, durch ein erfindungsgemäßes Photovoltaik-Modul (II) mit einer erfindungsgemäßen Glasscheibe (I) und mehreren Zwischenschichten,
Figur 5 eine Draufsicht auf eine erfindungsgemäße, strukturierte Oberfläche (1a) mit einem Lichtmikroskop,
Figur 6 eine vergrößerte Draufsicht gemäß der Figur 5, auf eine erfindungsgemäße, strukturierte Oberfläche (1a) mit einem Lichtmikroskop und
Figur 7 einen Ausschnitt aus einem Oberflächenprofil, gemessen mit einem Weisslichtinterferometer, einer erfindungsgemäßen strukturierten Oberfläche (1a).

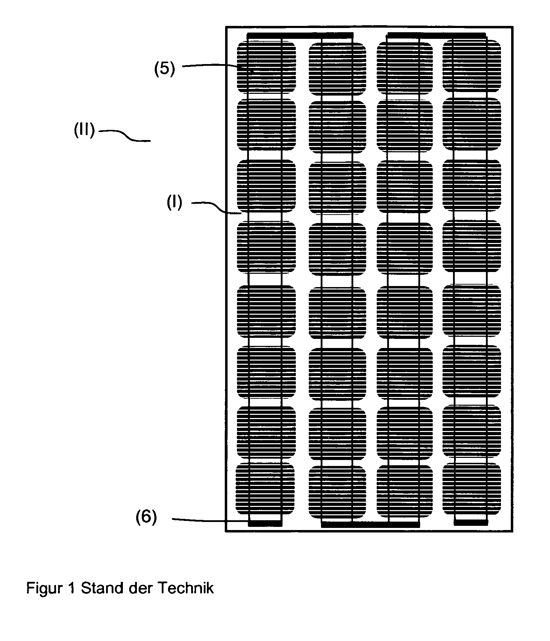

Figur 1 zeigt ein Photovoltaik-Modul (II) mit einem Deckglas (I) gemäß dem Stand der Technik. Das Deckglas (I) war eine 2,9 mm dicke, unstrukturierte Silikatglasscheibe und darunterliegend eine nicht dargestellte 0,36 mm dicke EVASAFE Polymer-Folie der Firma Bridgestone als Zwischenschicht (2). Darunterliegend bildeten Photovoltaikzellen (5) mit multikristallinem Silizium des Typs Q6LTT der q.cells SE und Stromsammelschienen (6) eine Reihenschaltung. Der Abstand D zwischen der Oberfläche des Deckglasses (I) und der Oberfläche der Photovoltaikzellen betrug etwa 3,3 mm. Der Mittenrauwert Ra des Deckglasses (I) war kleiner 100 nm und der Haze-Wert war kleiner 0,5 %. Die Energietransmission des Deckglases (I) betrug 90 %. Unter Bestrahlung in einem Winkel von 60 ° relativ zur senkrechten Einstrahlung und mit Sonnenlicht ähnlichem Spektrum wurde ein Kurzschlussstrom von 5,0 A gemessen. Die Formen und Oberflächen der Photovoltaikzellen (5) und Stromsammelschienen (6) waren durch das Deckglas (I) klar und deutlich sichtbar.

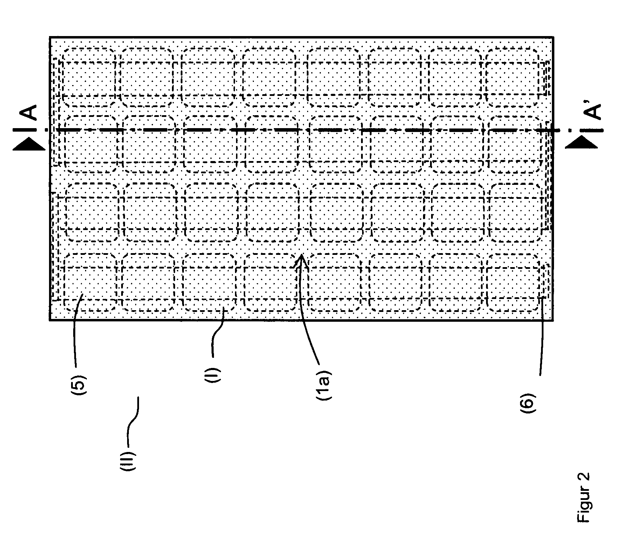

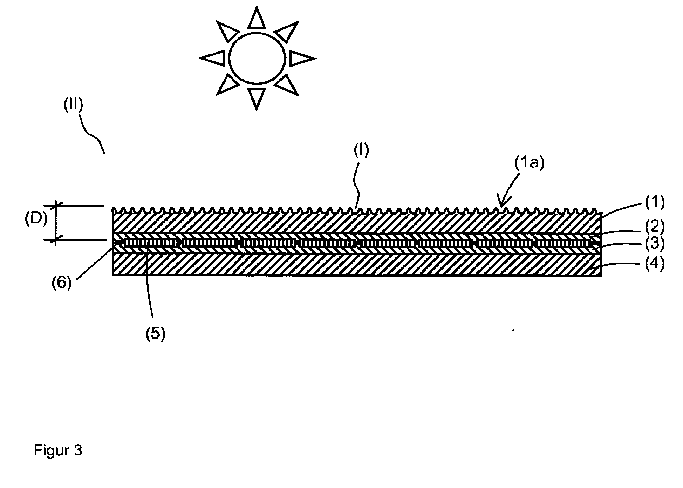

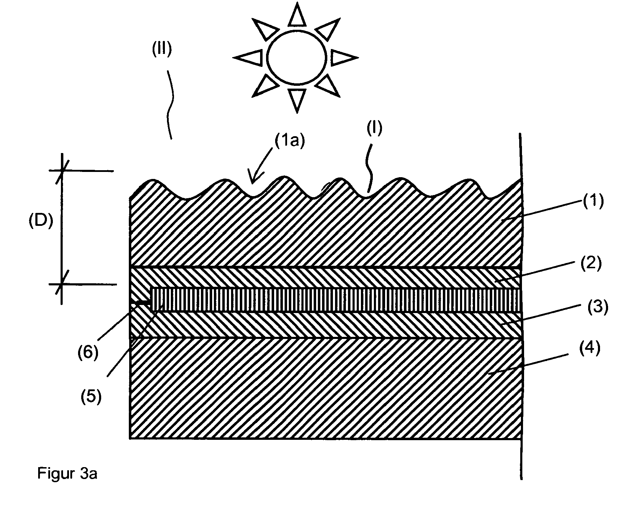

Die Figuren 2, 3 und 3a zeigen ein erfindungsgemäßes Ausführungsbeispiel eines Photovoltaik-Moduls (II) mit einer erfindungsgemäßen strukturierten Glasscheibe (I). Die erfindungsgemäße strukturierte Glasscheibe (I) wurde mit einer 2,9 mm dicken hochtransparenten Silikat-Floatglasscheibe (1) mit strukturierter Oberfläche (1a) gebildet. Als Zwischenschicht (2) enthielt das Photovoltaik-Modul (II) eine 0,76 mm dicke EVA EVASAFE Polymer-Folie, Q6LTT Photovoltaikzellen (5), eine 0,36 mm dicke EVASAFE weitere Zwischenschicht (3) und ein weiteres Silikat-Floatglas als rückseitige Schutzschicht (4). Die Energietransmission der strukturierten Glasscheibe (I) betrug 89 %. Die hochtransparente Silikat-Floatglasscheibe (1) enthielt 60 Gew.% bis 75 Gew.% SiO₂, 0 Gew.% bis 10 Gew.% Al₂O₃, etwa 0 Gew.% B₂O₃, 5 Gew.% bis 15 Gew.% CaO, 0 Gew.% bis 10 Gew.% MgO, 5 Gew.% bis 20 Gew.% Na₂O, 0 Gew.% bis 10 Gew.% K₂O, etwa 0 Gew.% BaO, >0,2 Gew.% bis 0,4 Gew.% SO₃, 0 Gew.% bis 0,015 Gew.% Fe₂O₃ (Gesamteisen) und ein Verhältnis FeO zu Fe₂O₃ (Gesamteisen) von 0,2 bis 0,4. Der Abstand D, wie in Figur 3a ersichtlich, betrug 3,7 mm. Der Mittenrauwert Ra der strukturierten Oberfläche (1a) betrug 2,4 µm bis 2,9 µm, die mittlere Rilllenbreite betrug 95 µm bis 110 µm, die Rautiefe Rz betrug 14,0 µm bis 16,5 µm und der Haze-Wert 93,0 % bis 94,5 %. Unter Bestrahlung mit Sonnenlicht in einem Winkel von 60 ° relativ zur senkrechten Einstrahlung und mit Sonnenlicht ähnlichem Spektrum wurde ein Kurzschlussstrom der Photovoltaikzellen (5) von 5,1 A gemessen. Die Lichtstreuung der strukturierten Glasscheibe (I) war gegenüber dem Vergleichsbeispiel stark erhöht. Die Energietransmission durch die strukturierte Glassscheibe (I) war kaum vermindert. Die Formen und Oberflächen der Photovoltaikzellen (5) und Stromsammelschienen (6) erschienen stark mattiert und unscharf. Ein Betrachter erkannte keine klaren Muster, Reflektionen oder Artefakte auf der Oberfläche (1a). Das Photovoltaik-Modul (II) wirkte für den Betrachter makroskopisch homogener und ästhetischer als ein Photovoltaik-Modul (II) nach dem Stand der Technik. Der elektrische Wirkungsgrad des erfindungsgemäßen Photovoltaik-Moduls (II) war gegenüber dem Vergleichsbeispiel leicht erhöht.

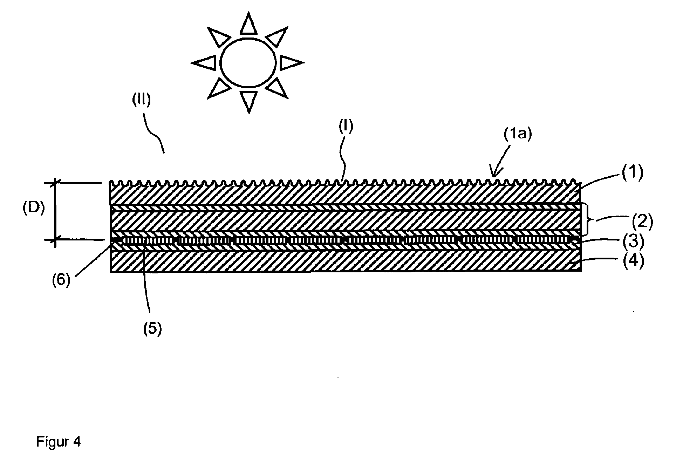

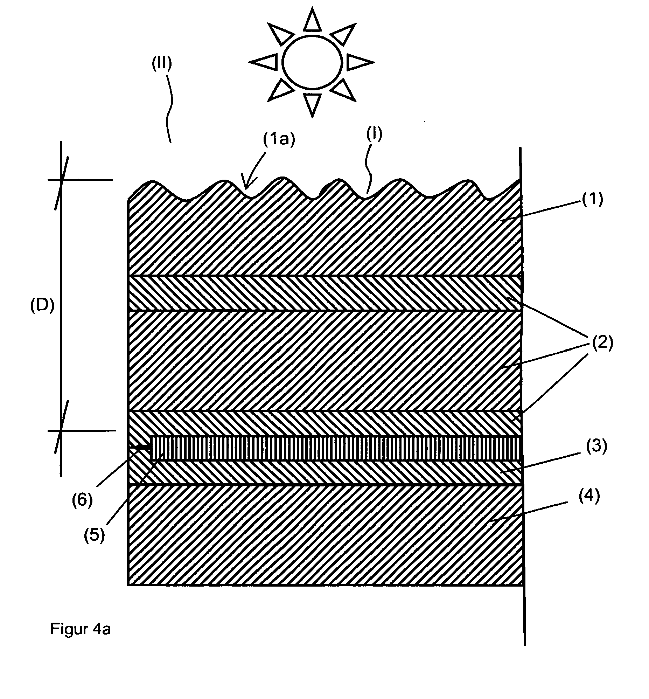

Figur 4 und 4 a zeigen in der weiteren Ausgestaltung der Erfindung gemäß Figur 3 ein Photovoltaik-Modul mit mehreren Zwischenschichten (2). Eine erste 0,38 mm dicke, transparente haftvermittelnde Zwischenschicht (2) mit EVASAFE war auf der dem Licht abgewandten Seite der 2,9 mm dicken, erfindungsgemäß strukturierten Glasscheibe (I) aufgebracht, darauf aufgebracht war ein weiteres 2,9 mm dickes, hochtransparentes Silikat-Floatglas (2) mit 60 Gew.% bis 75 Gew.% SiO₂, 0 Gew.% bis 10 Gew.% Al₂O₃, etwa 0 Gew.% B₂O₃, 5 Gew.% bis 15 Gew.% CaO, 0 Gew.% bis 10 Gew.% MgO, 5 Gew.% bis 20 Gew.% Na₂O, 0 Gew.% bis 10 Gew.% K₂O, etwa 0 Gew.% BaO, >0,2 Gew.% bis 0,4 Gew.% SO₃, 0 Gew.% bis 0,015 Gew.% Fe₂O₃ (Gesamteisen) und ein Verhältnis FeO zu Fe₂O₃ (Gesamteisen) von 0,2 bis 0,4., darauf aufgebracht war eine weitere 0,38 mm dicke haftvermittelnde Zwischenschicht (2) mit EVASAFE und darauf aufgebracht der weitere Aufbau mit einer Schaltung von Photovoltaikzellen (5) gemäß der Figur 3. Der Abstand D, wie in Figur 4a ersichtlich, betrug 6,6 mm. Der Kurzschlussstrom der Photovoltaikzellen (5) betrug etwa 5,0 A. Die Formen und Oberflächen der Photovoltaikzellen (5) und Stromsammelschienen (6) erschienen stark mattiert, unscharf. Ein Betrachter erkannte keine klaren Muster, Reflektionen oder Artefakte auf der Oberfläche (1a). Das Photovoltaik-Modul (II) wirkte für den Betrachter makroskopisch homogener und ästhetischer als ein Photovoltaik-Modul (II) nach dem Stand der Technik. Der elektrische Wirkungsgrad des erfindungsgemäßen Photovoltaik-Moduls (II) war gegenüber dem Vergleichsbeispiel nicht vermindert.

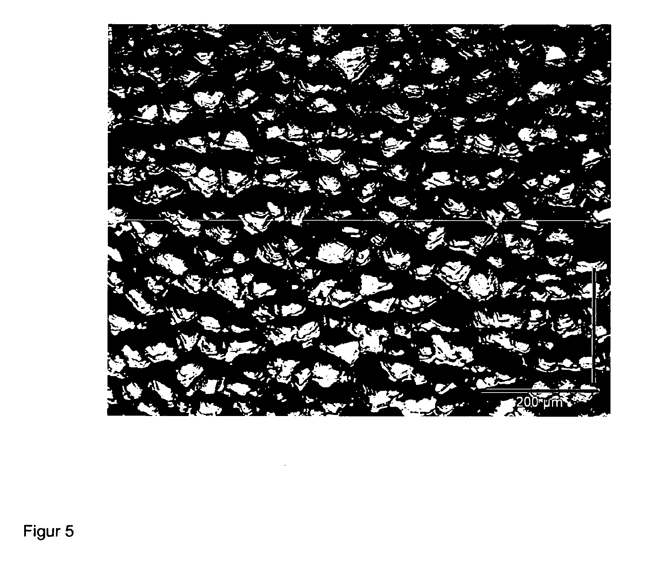

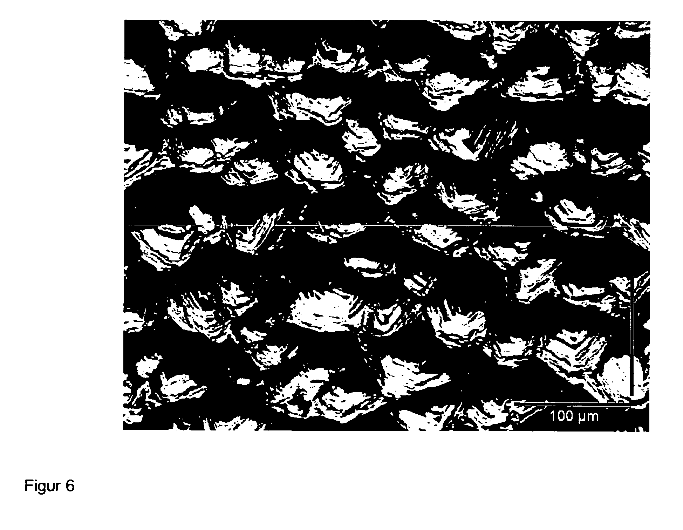

Draufsichten auf die erfindungsgemäße, strukturierte Oberfläche (1a) mit einem Lichtmikroskop sind in den Figuren 5 und 6 gezeigt. Man erkennt mit zunehmender Vergrößerung die mikroskopisch feinen Vertiefungen und Erhebungen, dargestellt mit einem Schwarz-Weiss Kontrast. Makroskopisch bildeten die mikroskopischen Vertiefungen und Erhebungen in der Glasoberfläche für den Betrachter eine homogen mattierte, ästhetische Oberfläche (1a).

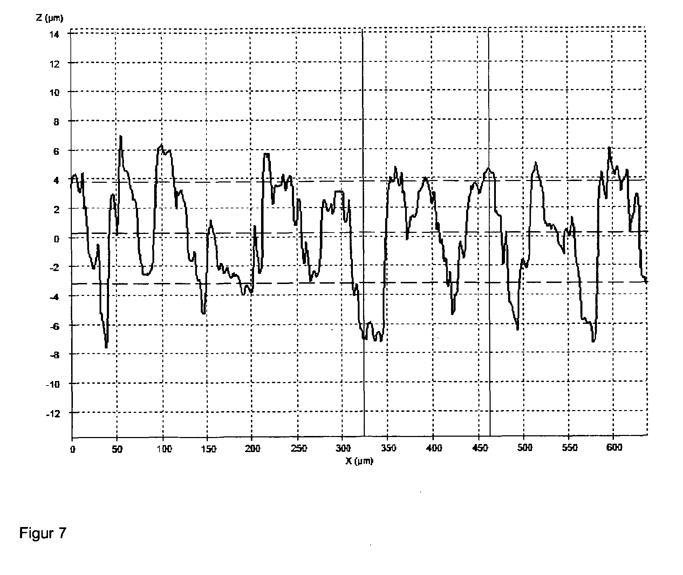

Ein Oberflächenprofil eines erfindungsgemäßen Ausführungsbeispiels der strukturierten Glasscheibe (I) ist in Figur 7 gezeigt. Es wurden Strukturtiefen (z-Richtung) von etwa 5 µm bis 10 µm und Strukturbreiten (x-Richtung) von etwa 50 µm bis 100 µm gemessen.

Es wurde gefunden, dass die Schaltung von Photovoltaikzellen (5) und Stromsammelschienen (6) erfindungsgemäß unscharf, schemenhaft und stark mattiert auf der Oberfläche (1a) des erfindungsgemäßen Photovoltaik-Moduls (II) abgebildet wurden und auf den Betrachter ästhetisch wirkten. Der elektrische Wirkungsgrad war gegenüber dem Vergleichsbeispiel stabil oder erhöht.

### Bezugszeichenliste:

(I) Strukturierte hochtransparente Glasscheibe / Deckglas,
(II) Photovoltaik-Modul,
   (1) Hochtransparente Glasscheibe,
      (1a) Oberflächenstruktur der dem Lichteinfall zugewandten Oberfläche (1a) der hochtransparenten Glasscheibe (1),
   (2) Zwischenschicht,
   (3) weitere Zwischenschicht,
   (4) Schutzschicht / Rückseitenglas,
   (5) Schaltung von Photovoltaikzellen,
   (6) Stromsammelschiene,
      (D) Abstand zwischen der Oberfläche der Photovoltaikzellen (6) und der dem Lichteinfall zugewandten, strukturierten Oberfläche (1a) der transparenten Glasscheibe (I).

## Patentansprüche

1. Strukturierte Glasscheibe (I) mit einer Oberflächenstruktur (1a) auf mindestens einem Teilbereich einer transparenten Glasscheibe (1), wobei die Oberflächenstruktur (1a) einen Mittenrauwert Ra von 2,0 µm bis 3,5 µm, eine mittlere Rillenbreite Rsm von 80 µm bis 120 µm und eine Rautiefe Rz von 5 µm bis 50 µm hat.

2. Glasscheibe (I) nach Anspruch 1, wobei die Oberflächenstruktur (1 a) eine Lichtstreuung von mindestens 70%, bevorzugt mindestens 90 % und besonders bevorzugt mindestens 92% hat.

3. Glasscheibe (I) nach Anspruch 1 oder 2, wobei die Glasscheibe (I) eine Energietransmission von mindestens 80 %, bevorzugt mindestens 87 % und besonders bevorzugt mindestens 90% hat.

4. Glassctieibe (I) nach einem der Ansprüche 1 bis 3 , wobei die hochtransparente Glasscheibe (1) einseitig und vollflächig die Oberflächenstruktur (1a) aufweiset.

5. Glasscheibe (1) nach einem der Ansprüche 1 bis 4, wobei die strukturierte Glasscheibe (1) ein vorgespanntes Sicherheitsglas ist.

6. Photovoltaik-Modul (II), umfassend eine strukturierte Glasscheibe (I) nach einem der Ansprüche 1 bis 5, wobei die Oberflächenstruktur (1a) dem Lichteinfall zugewandt ist und
- mindestens eine Zwischenschicht (2) auf der dem Lichteinfall abgewandten Oberfläche der strukturierten Glasscheibe (I) aufgebracht ist,
- auf der Zwischenschicht (2) eine Schaltung von Photovoltaikzellen (5) aufgebracht ist,
- eine weitere Zwischenschicht (3) und/oder Schutzschicht (4) auf der Schaltung von Photovoltaikzellen (5) aufgebracht ist.

7. Photovoltaik-Modul (II) nach Anspruch 6, wobei der Abstand D zwischen der Oberfläche der Schaltung von Photovoltaikzellen (5) und der dem Lichteinfall zugewandten strukturierten βberfläche (1a) 1,8 mm bis 10 mm und bevorzugt 3,5 mm bis 8 mm beträgt und besonders bevorzugt 3,7 mm bis 7 mm.

8. Photovoltaik-Modul (II) nach Anspruch 6 oder 7 , wobei die Zwischenschicht (2) einen Verbund aus mindestens 2 Schichten enthält.

9. Photovoltaik-Modul (II) nach einem der Ansprüche 6 bis 8, wobei die Schaltung von Photovoltaikzellen (5) Silizium-Photovoltaikzellen, Photovoltaikzellen mit Chalcopyrit oder Photovoltaikzellen mit Kadmium-Tellurid enthält.

10. Photovoltaik-Modul (II) nach einem der Ansprüche 6 bis 9, wobei die Zwischenschicht (2) Silikatglas, Ethylen-Vinyl-Acetate, Ethyl-Acryl-Acetate, Ethylen-Methacrylate, katalysierte Polyethylene, plastizierte Polyvinylchloride, plastizitierte Polyvinyl-Butyrale, Polyethylen-Terephthalate, Polystyrol, Polyamid, Polyester, Polyvinylchlorid, Polycarbonat, Polymethylmethacrylat und / oder Polyurethane, sowie Kopolymere und / oder Gemische davon enthält.

11. Photovoltaik-Modul (II) nach einem der Ansprüche 6 bis 9, wobei die Schutzschicht (4) Silikatglas, Fluorpolymere, Vinyl-Fluoride, Fluorinierte Ethylen-Propylene, Polyvinylfluorid, Ethylen-Tetrafluorethylen, Ethylen-Vinyl-Acetate, Ethyl-Acryl-Acetate, Ethylen-Methacrylate, katalysierte Polyethylene, plastizierte Polyvinylchloride, plastizitierte Polyvinyl-Butyrale, Polyurethane, Kopolymere und / oder Gemische davon enthält.

12. Verwendung eines Photovoltaik-Moduls (II) mit strukturierter Glasscheibe (I) nach den vorhegehen den Ansprüchen in der Bau- oder Architekturverglasung.

## Claims

1. Structured glass plate (I) with a surface structure (1a) on at least a part of a transparent glass plate (1), wherein the surface structure (1a) has a mean roughness Ra of 2.0 µm to 3.5 µm, a mean groove width Rsm of 80 µm to 120 µm, and a surface roughness Rz of 5 µm to 50 µm.

2. Glass plate (I) according to claim 1, wherein the surface structure (1a) has light scattering of at least 70%, preferably at least 90 %, and particularly preferably at least 92%.

3. Glass plate (I) according to claim 1 or 2, wherein the glass plate (I) has energy transmission of at least 80 %, preferably at least 87 %, and particularly preferably at least 90%.

4. Glass plate (I) according to one of claims 1 through 3, wherein the highly transparent glass plate (1) has the surface structure (1a) on one side only and over the entire surface.

5. Glass plate (I) according to one of claims 1 through 4, wherein the structured glass plate (I) is a prestressed safety glass.

6. Photovoltaic module (II), comprising a structured glass plate (I) according to one of claims 1 through 5, wherein the surface structure (1a) faces the incidence of light and
- at least one intermediate layer (2) is applied on the surface of the structured glass plate (I) facing away from the incidence of light,
- a circuit of photovoltaic cells (5) is applied on the intermediate layer (2), and
- another intermediate layer (3) and/or protective layer (4) is applied on the circuit of photovoltaic cells (5).

7. Photovoltaic module (II) according to claim 6, wherein the distance D between the surface of the circuit of photovoltaic cells (5) and the structured surface (1a) facing the incidence of light is 1.8 mm to 10 mm and preferably 3.5 mm to 8 mm and particularly preferably 3.7 mm to 7 mm.

8. Photovoltaic module (II) according to claim 6 or 7, wherein the intermediate layer (2) contains a composite of at least 2 layers.

9. Photovoltaic module (II) according to one of claims 6 through 8, wherein the circuit of photovoltaic cells (5) contains silicon photovoltaic cells, photovoltaic cells with chalcopyrite, or photovoltaic cells with cadmium telluride.

10. Photovoltaic module (II) according to one of claims 6 through 9, wherein the intermediate layer (2) contains silicate glass, ethylene vinyl acetates, ethyl acrylic acetates, ethylene methacrylates, catalyzed polyethylenes, plasticized polyvinyl chlorides, plasticized polyvinyl butyrals, polyethylene terephthalates, polystyrene, polyamide, polyester, polyvinyl chloride, polycarbonate, polymethyl methacrylate, and / or polyurethane, as well as copolymers and / or mixtures thereof.

11. Photovoltaic module (II) according to one of claims 6 through 9, wherein the protective layer (4) contains silicate glass, fluoropolymers, vinyl fluorides, fluorinated ethylene propylenes, polyvinyl fluoride, ethylene tetrafluoroethylene, ethyl vinyl acetates, ethyl acrylic acetates, ethylene methacrylates, catalyzed polyethylenes, plasticized polyvinyl chlorides, plasticized polyvinyl butyrals, polyurethane, copolymers, and / or mixtures thereof.

12. Use of a photovoltaic module (II) with a structured glass plate (I) according to the preceding claims in structural or architectural glazing.

## Revendications

1. Feuille de verre structurée (I) comportant une structure superficielle (Ia) sur au moins une zone partielle d'une feuille de verre transparente (I), la structure superficielle (Ia) ayant une valeur de rugosité moyenne Ra de 2,0 µm à 3,5 µm, une largeur moyenne de sillon Rsm de 80 µm à 120 µm et une profondeur de rugosité Rz de 5 µm à 50 µm.

2. Feuille de verre (1) selon la revendication 1, dans laquelle la structure superficielle (1a) a une diffusion de lumière d'au moins 70 %, de préférence d'au moins 90 % et de façon particulièrement préférée encore d'au moins 92 %.

3. Feuille de verre (1) selon l'une des revendications 1 ou 2, dans laquelle la feuille de verre (1) a une transmission d'énergie d'au moins 80 %, de préférence d'au moins 87 % et de façon particulièrement préférée d'au moins 90 %.

4. Feuille de verre (1) selon l'une des revendications 1 à 3, dans laquelle la feuille de verre (1) hautement transparente présente la structure superficielle (1a) sur une face et sur toute la surface.

5. Feuille de verre (1) selon l'une des revendications 1 à 4, dans laquelle la feuille de verre structurée (1) est un verre de sécurité précontraint.

6. Module photovoltaïque (II), comprenant une feuille de verre structurée (1) selon l'une des revendications 1 à 5, dans lequel la structure superficielle (1a) est tournée en direction de la lumière incidente et dans laquelle :
- au moins une couche intermédiaire (2) est appliquée sur la surface de la feuille de verre structurée (1) opposée à la direction de la lumière incidente ;
- un circuit de cellules photovoltaïques (5) est appliqué sur la couche intermédiaire (2) ;
- une autre couche intermédiaire (3) et/ou une couche de protection (4) est appliquée sur le circuit de cellules photovoltaïques (5).

7. Module photovoltaïque (II) selon la revendication 6, dans lequel la distance D entre la surface du circuit de cellules photovoltaïques (5) et la surface structurée (1a) tournée en direction de la lumière incidente est de 1,8 mm à 10mm, de préférence de 3,5 mm à 8 mm et de façon particulièrement préférée de 3,7 mm à 7 mm.

8. Module photovoltaïque (II) selon l'une des revendications 6 ou 7, dans lequel la couche intermédiaire (2) contient un composite fait d'au moins 2 couches.

9. Module photovoltaïque (II) selon l'une des revendications 6 à 8, dans lequel le circuit de cellules photovoltaïques (5) contient des cellules photovoltaïques au silicium, des cellules photovoltaïques avec de la chalcopyrite ou des cellules photovoltaïques avec du tellurure de cadmium.

10. Module photovoltaïque (II) selon l'une des revendications 6 à 9, dans lequel la couche intermédiaire (2) contient du verre de silicate, de l'éthylène-acétate de vinyle, de l'acétate d'éthyle-acryle, de l'éthylène-méthacrylate, des polyéthylènes catalysés, des poly(chlorures de vinyle) plastifiés, des butyrals polyvinyliques plastifiés, des poly(téréphtalates d'éthylène), du polystyrène, du polyamide, du polyester, du poly(chlorure de vinyle), du polycarbonate, du poly(méthacrylate de méthyle) et/ou des polyuréthanes, ainsi que des copolymères et/ou des mélanges de ceux-ci.

11. Module photovoltaïque (II) selon l'une des revendications 6 à 9, dans lequel la couche de protection (4) contient du verre de silicate, des polymères fluorés, des fluorures de vinyle, de l'éthylène-propylène fluoré, du poly(fluorure de vinyle), de l'éthylène-tétrafluoréthylène, de l'éthylène-acétate de vinyle, de l'acétate d'éthyle-acryle, de l'éthylène-méthacrylate, des polyéthylènes catalysés, des poly(chlorures de vinyle) plastifiés, des butyrals polyvinyliques plastifiés, des polyuréthanes, des copolymères et/ou des mélanges de ceux-ci.

12. Utilisation d'un module photovoltaïque (11) ayant une feuille de verre structurée (1) selon les revendications précédentes dans les vitrages de bâtiments ou architecturaux.
